(19) Europäisches Patentamt
European Patent Office
Office européen des brevets

(11) EP 2 126 996 B1

(12) **EUROPÄISCHE PATENTSCHRIFT**

(45) Veröffentlichungstag und Bekanntmachung des Hinweises auf die Patenterteilung:
**03.10.2012 Patentblatt 2012/40**

(21) Anmeldenummer: **08706873.0**

(22) Anmeldetag: **05.02.2008**

(51) Int Cl.:
***H01L 51/00*** *(2006.01)*

(86) Internationale Anmeldenummer:
**PCT/DE2008/000213**

(87) Internationale Veröffentlichungsnummer:
**WO 2008/106917 (12.09.2008 Gazette 2008/37)**

(54) **ELEKTRISCHES ORGANISCHES BAUELEMENT MIT RHENIUM-DOTIERSTOFF UND VERFAHREN ZU SEINER HERSTELLUNG**

ELECTRIC ORGANIC COMPONENT WITH RHENIUM DOPANT MATERIAL, AND METHOD FOR THE PRODUCTION THEREOF

COMPOSANT ORGANIQUE ÉLECTRIQUE À SUBSTANCE DOPANTE RHÉNIUM ET PROCÉDÉ POUR LE PRODUIRE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **02.03.2007 DE 102007010243**
**23.05.2007 DE 102007023876**

(43) Veröffentlichungstag der Anmeldung:
**02.12.2009 Patentblatt 2009/49**

(73) Patentinhaber: **OSRAM Opto Semiconductors GmbH**
**93055 Regensburg (DE)**

(72) Erfinder:
- **SCHMID, Günter**
**91334 Hemhofen (DE)**
- **GÖÖTZ, Britta**
**93049 Regensburg (DE)**
- **HEUSER, Karsten**
**91056 Erlangen (DE)**
- **SCHERER, Wolfgang**
**86391 Leitershofen (DE)**
- **HERRMANN, Rudolf**
**86156 Augsburg (DE)**
- **SCHEIDT, Ernst-Wilhelm**
**86420 Diedorf/Biburg (DE)**

(74) Vertreter: **Epping - Hermann - Fischer Patentanwaltsgesellschaft mbH**
**Ridlerstrasse 55**
**80339 München (DE)**

(56) Entgegenhaltungen:
**WO-A-2006/121105**
**US-A1- 2004 013 905**
**US-A1- 2006 076 537**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 126 996 B1

## Beschreibung

Die Erfindung betrifft ein elektrisches organisches Bauelement mit einer ersten elektrisch halbleitenden Schicht und ein Verfahren zu seiner Herstellung.

Elektrische organische Bauelemente, wie z. B. organische Leuchtdioden, mit organischen Funktionsschichten weisen eine Effizienz und eine Lebensdauer auf, die unter anderem davon abhängen, wie gut die Ladungsträgerinjektion aus den Elektroden in die organischen Funktionsschichten erfolgt. US2006/0076537 offenbart organisch leucht dioden, die Rhenium komplexe als Dotanden aufweist.

Aufgabe der Erfindung ist es, ein elektrisches organisches Bauelement bereitzustellen, das eine verbesserte Ladungsträgerinjektion von einer Elektrode in eine organische Funktionsschicht ermöglicht.

Diese Aufgabe wird durch ein elektrisches organisches Bauelement gemäß dem Anspruch 1 gelöst. Besonders vorteilhafte Ausgestaltungen des elektrisch organischen Bauelements und ein Verfahren für dessen Herstellung sind Gegenstand weiterer Ansprüche.

In einem elektrischen organischen Bauelement gemäß eines Ausführungsbeispiels der Erfindung ist eine erste elektrisch halbleitende Schicht vorhanden, die mit einem Dotierstoff dotiert ist, der Rheniumverbindungen umfasst. Ein solches elektrisches organisches Bauelement weist ein Substrat auf, eine erste Elektrode, eine erste elektrisch halbleitende Schicht auf der ersten Elektrode, eine organische Funktionsschicht auf der elektrisch halbleitenden Schicht, und eine zweite Elektrode auf der organischen Funktionsschicht. Auf dem Substrat kann entweder die erste oder die zweite Elektrode angeordnet sein. Durch die Dotierung der ersten elektrisch halbleitenden Schicht mit einem Dotierstoff, der Rheniumverbindungen umfasst, kann eine höhere Effizienz des elektrischen organischen Bauelements erreicht werden. Weiterhin kann damit die Lebensdauer des elektrischen organischen Bauelements erhöht werden und es ist keine Beschränkung mehr bezüglich der Materialien für die erste Elektrode notwendig. Weiterhin ist die Dotierung mit Rheniumverbindungen stabil. Die Erfinder haben festgestellt, dass durch die Dotierung der ersten elektrisch halbleitenden Schicht mit Rheniumverbindungen der Spannungsabfall zwischen der ersten Elektrode und der organischen Funktionsschicht reduziert werden kann. Weiterhin kann dadurch ein guter ohmscher Kontakt zwischen der ersten Elektrode und der organischen Funktionsschicht erzeugt werden.

Der Ausdruck "auf" in Bezug auf die Schichtenfolge in dem elektrischen organischen Bauelement bedeutet, dass sich beispielsweise die elektrisch halbleitende Schicht in direktem Kontakt mit der ersten Elektrode befinden kann, dass aber auch noch weitere Schichten zwischen der ersten Elektrode und der elektrisch halbleitenden Schicht vorhanden sein können.

Gemäß einer Weiterbildung der Erfindung weist die elektrisch halbleitende Schicht ein Matrixmaterial auf, in dem der Dotierstoff vorhanden ist. Weiterhin kann das Matrixmaterial durch den Dotierstoff p-dotiert sein. Dadurch kann in dem Matrixmaterial eine positive Ladung oder Partialladung in den, den Ladungsträgertransport vermittelnden Energieniveaus erzeugt werden. Dabei kann bei einer p-Dotierung das niedrigste nicht-besetzte Orbital (LUMO) des Dotierstoffes energetisch nahe oder sogar unter dem höchsten besetzten Orbital (HOMO) des Matrixmaterials lokalisiert sein, mit der Folge, dass ein Elektron vom HOMO des Matrixmaterials auf das LUMO des Dotierstoffes übergeht und so eine positive Ladung bzw. Partialladung im Matrixmaterial erzeugt wird.

Gemäß einer weiteren Ausführungsform der Erfindung ist das Matrixmaterial ein Loch- bzw. Defektelektronentransportierendes Material. Diese Matrixmaterialien enthalten z. B. Stickstoff, Sauerstoff, Schwefel, Selen, Phosphor und Arsengruppen, sowie beliebige Kombinationen davon, die gut Elektronen bzw. negative Partialladungen auf einen p-Dotierstoff übertragen können.

Weiterhin kann das Matrixmaterial aus einer Gruppe ausgewählt sein, die Phenantrolinderivate, Imidazolderivate, Thiazolderivate, Oxadiazolderivate, Phenyl-haltige Verbindungen, Verbindungen mit kondensierten Aromaten, Carbazol-haltige Verbindungen, Fluorenderivate, Spirofluorenderivate und Pyridin-haltige Verbindungen sowie beliebige Kombinationen der genannten Materialien umfasst. Ein Beispiel für ein Phenantrolinderivat ist das in Formel 1 gezeigte 4,7-Diphenyl-1,10-phenantrolin (Bphen):

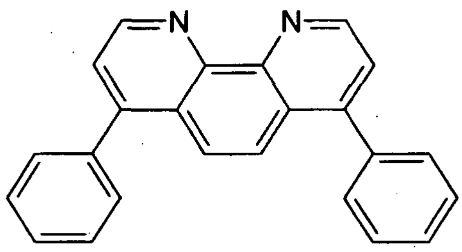

Formel 1

Ein weiteres Beispiel für ein Phenantrolinderivat ist das in Formel 2 gezeigte 2,9-Dimethyl-4,7-diphenyl-1,10-phenantrolin (BCP):

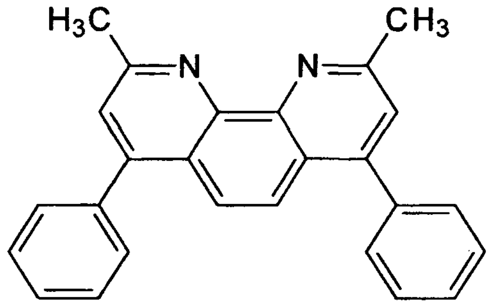

Formel 2

Ein Beispiel für Imidazolderivate ist 1,3,5-Tris-(1-phenyl-1H-benzimidazol-2-yl)-benzen (TPBi), für Triazolderivate 3-Phenyl-4-(1'-naphthyl) -5-phenyl-1,2,4-triazol (TAZ). Als Oxazolderivat kann beispielsweise ((2,4-Biphenylyl)-5-(4-tert-buthylphenyl)-1,3,4-oxadiazol) (Bu-PBD) eingesetzt werden. Beispiele für Phenyl-haltige Verbindungen und Verbindungen mit kondensierten Aromaten sind Naphthyl-phenyl-diamin (NPD), (4,4'-Bis (2,2-diphenyl-ethen-1-yl)-diphenyl) (DPVBi), Rubren, (N,N'-Bis(naphtalen-1-yl)-N,N'-Bis(phenyl)benzidin) ($\alpha$-NPD = NPB), (4,4',4"-Tris (N-(naphth-1-yl)-N-phenyl-amino)triphenylamin) (1-TNATA). Als Carbazol-haltige Verbindungen können z. B. (4,4'-Bis (9-ethyl-3-carbazovinylen)1,1'-biphenyl) (BCzVBi) aber auch kleinere Carbazolderivate wie beispielsweise (4,4'-Bis(carbazol-9-yl)biphenyl) (CBP) eingesetzt werden. Diese Verbindungen haben wie bereits oben genannt Donorgruppen wie beispielsweise Stickstoff, Sauerstoff, Schwefel oder Phosphor, die besonders geeignet für die Dotierung mit Rheniumverbindungen sind. Weiterhin können die Rheniumverbindungen als Lewis-Säure die im Matrixmaterial vorhandenen Aromaten polarisieren und somit eine Dotierung, insbesondere eine p-Dotierung bewirken.

Die Rheniumverbindungen sind Rhenium-oxo-verbindungen .

Nach einer weiteren Ausführungsform sind die Rheniumverbindungen Lewissäuren und können aus einer Gruppe ausgewählt sein, die Rheniumoxide, metallorganische Derivate von Rheniumoxiden, Rheniumoxyhalogenide und Mischungen daraus umfasst. Diese Verbindungen sind in der Regel relativ starke LewisSäuren mit geringem oxidierenden Charakter. Eine geringe oxidierende Wirkung bewirkt, dass die organische Matrix nicht irreversibel angegriffen wird. Zudem sind die Verbindungen leicht sublimierbar und damit prozessierbar bei Temperaturen von 200 bis 300°C aufgrund ihres relativ geringen Molekulargewichts und ihres nicht-polymeren Charakters.

In einer nicht erfundungsgemaßen Ausführungsform umfasst der Dotierstoff $Re_2O_7$ (Rheniumheptoxid). Auch $Re_2O_7$ ist eine relativ starke Lewis-Säure mit geringem oxidierenden Charakter.

Erfindungsgemäß umfasst der Dotierstoff eine $ReO_3$-Einheit, an die ein Rest M gebunden ist, der organisch sein kann. Die $ReO_3$-Einheit weist eine geringe Oxidationskraft auf, so dass sie in Verbindung mit Kohlenstoffgerüsten stabil ist.

Weiterhin kann der Rest M an die $ReO_3$-Einheit $\sigma$-gebunden sein. Aufgrund der außerordentlichen Redox-Stabilität der $ReO_3$-Einheit ist eine metallorganische Verbindung mit einem $\sigma$-gebundenen Kohlenstoffgerüst stabil. Weiterhin eignet sich die $ReO_3$-Einheit, an die ein organischer Rest M gebunden ist, für die Dotierwirkung, da sie einen besonderen Lewis-sauren Charakter hat.

Günstigerweise ist der Rest M aus einer Gruppe ausgewählt, die verzweigte oder unverzweigte gesättigte aliphatische Gruppen, verzweigte und unverzweigte ungesättigte aliphatische Gruppen, Aromaten, Anionen der Carbonsäuren, Halogene, Stanylreste und Silylreste umfasst. Bei den gesättigten oder ungesättigten aliphatischen Gruppen kann es sich beispielsweise um Methyl-, Ethyl-, und Propylgruppen, aber auch um substituierte Aliphaten wie beispielsweise Benzyl- oder Fluoro-Aliphaten handeln. Beispiele für Aromaten können Phenyl, Indenyl, und Mesityl sein. Acetat, Trifluoroacetat und Toluolsulfonat sind Beispiele für Anionen der Carbonsäuren bzw. organischen Säuren. Als Silylrest kann beispielsweise Trimethylsilyl eingesetzt werden, und als Halogene beispielsweise Chlorid, Bromid, und lodid. Diese Reste M können mit der $ReO_3$-Einheit eine stabile $\sigma$-Bindung eingehen. Weiterhin können die aliphatischen Gruppen, die Aromaten und die Anionen der Carbonsäuren weitere Substituenten aufweisen. Günstigerweise handelt es sich dabei um Donorsubstituenten, wie beispielsweise Amine, Phosphane oder Thiole. Diese Substituenten können die p-dotierende Winkung des Dotierstoffs verstärken. In einer weiteren Ausführungsform kann der Rest M an die $ReO_3$-Einheit $\pi$-gebunden sein. Weiterhin kann der Rest M unsubstituiertes oder substituiertes Cyclopentadienyl umfassen, das die

Strukturformel ($C_5R_xH_{5-x}$) aufweist, mit x = 1-5. R kann dabei Substituenten umfassen, die unabhängig voneinander einen Alkylrest, z. B: Methyl-, Ethyl- oder einen Arylrest, z. B: Phenylrest umfassen. Auch die Rhenium-Oxide mit π-gebundenen organischen Resten M können stabile Verbindungen mit dem Matrixmaterial eingehen und Lewis-sauer sein.

Erfindungsgemäß bilden der Dotierstoff und das Matrixmaterial einen Komplex. Der Dotierungsmechanismus wird beispielhaft in nicht erfindungsgemäßer Formel 3 verdeutlicht:

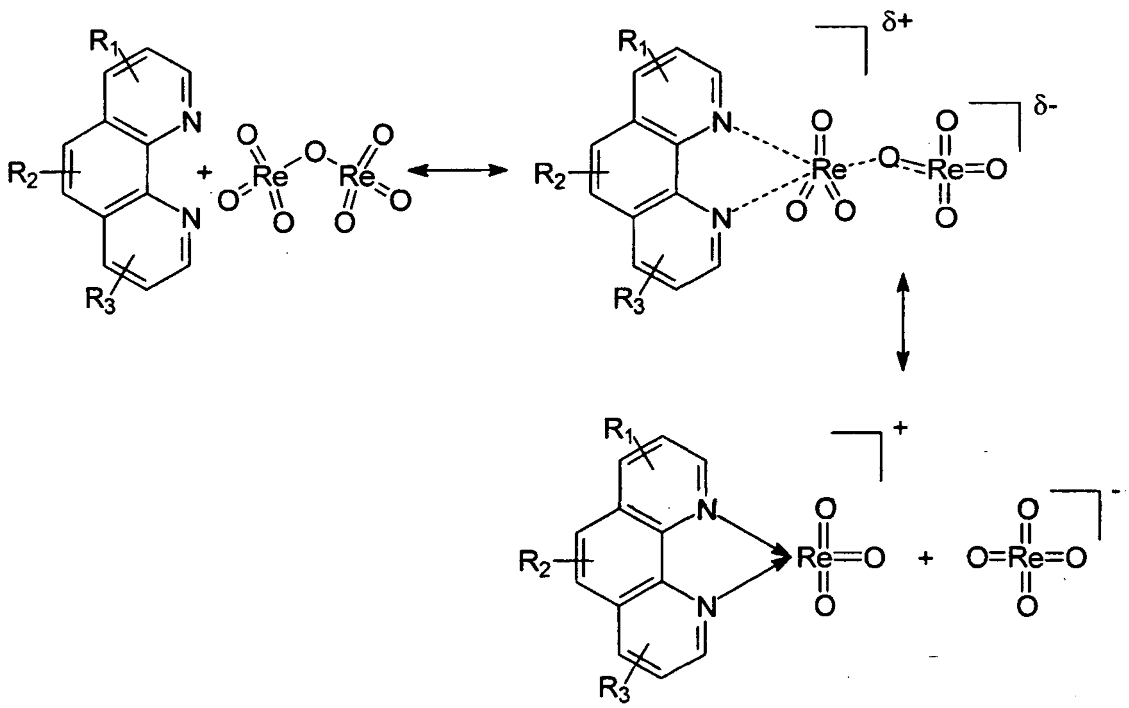

Formel 3

Hier sind die Grenzstrukturen des Dotierungsmechanismus zu sehen. Die Matrix ist in diesem Beispiel ein Phenantrolinderivat, das mit $R_1$, $R_2$ und $R_3$ sowie weiteren Resten beliebig substituiert sein kann, der Dotierstoff ist $Re_2O_7$. Es wird eine positive Partialladung $\delta^+$ auf die phenantrolinbasierte Matrix übertragen, wodurch sie p-dotiert wird. Da sich die beiden Rhenium-Atome in unmittelbarer Nähe der Matrix befinden, können sie über die Sauerstoffbrücke reversibel, Redoxneutral oder heterolytisch kombinieren beziehungsweise spalten. Die besondere thermodynamische Stabilität des Perrhenatanios $ReO_4^-$ fördert zusätzlich die Dotierwirkung.

Die Dotierwirkung der $ReO_3$-Einheit mit σ- oder π-gebundenen Kohlenstoffgerüsten ist beispielhaft in Formel 4 zu sehen.

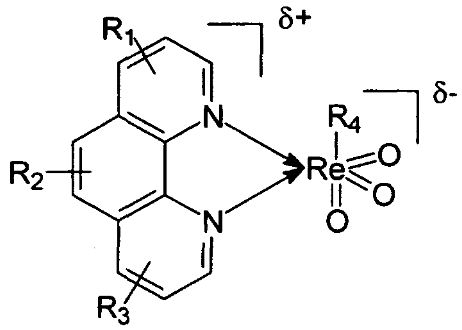

Formel 4

Die Reste $R_1$, $R_2$ und $R_3$ stehen beispielhaft für die Substitutionsmuster an den Aromaten. Es können auch mehr oder weniger Substituenten vorhanden sein. Die Auswahl an Substituenten ist nicht beschränkt. Auch die $ReO_3$-Einheit mit σ- oder π-gebundenen Kohlenstoffgerüsten bilden stabile Komplexe, die über die Partialladungen $\delta^+$ und $\delta^-$ mit dem Matrixmaterial stabilisiert sind. Die Komplexe der Formel 3 und der Formel 4 sind thermisch bis ca. 400°C stabil und eignen sich daher gut für die Dotierfunktion in elektrisch organischen Bauelementen, auch wenn diese bei hohen Temperaturen betrieben werden.

Das Molverhältnis Matrix zu Dopant kann dabei zwischen 0,001 und 1 variiert werden.

In einer weiteren Ausführungsform umfasst die elektrisch halbleitende Schicht eine Ladungstransport-/Ladungsinjektionsschicht bzw. hat die elektrisch halbleitende Schicht die Funktion einer Ladungstransport-/Ladungs-injektionsschicht. Die elektrisch halbleitende Schicht kann Ladungen von oder zur ersten Elektrode transportieren. Weiterhin kann es sich bei der Ladungstransport-/Injektionsschicht um eine Lochtransport-/Lochinjektionsschicht handeln. In diesem Fall können positive Ladungen von der ersten Elektrode hin zur organischen Funktionsschicht transportiert werden unter der Bedingung, dass die erste Elektrode als Anode geschaltet ist.

In einer weiteren Ausführungsform kann die erste Elektrode eine Anode umfassen oder als Anode geschaltet sein. Weiterhin kann das Material der ersten Elektrode aus einer Gruppe ausgewählt sein, die Metalle und deren Legierungen, Edelmetalle und deren Legierungen, Metalloxide und dotierte Polymere sowie Kombinationen davon umfasst. Aufgrund der Dotierung ist das Material für die Anode nicht auf Materialien mit besonders hoher Austrittsarbeit beschränkt. Somit können neben den klassischen Materialien für Anoden wie beispielsweise die Edelmetalle Au, Pd, Pt oder deren Legierungen, oxidische Leiter wie ITO (Indium-Zinnoxid) oder dotierte Polymere, wie mit Polystyrolsulfonsäure dotiertes Poly(3,4-ethylendioxythiophen) oder mit Camphersulfonsäure dotiertes Polyanilin, auch beliebige Metalle wie Edelstahl oder Aluminium oder Aluminium-Legierungen für die Anode geeignet sein.

In einer weiteren Ausführungsform ist das Bauelement aus einer Gruppe ausgewählt, die Feldeffekttransistoren, Solarzellen und Photodetektoren umfasst. Weiterhin kann das Bauelement eine Leuchtdiode umfassen. Die Dotierung der elektrisch halbleitenden Schicht in einer Leuchtdiode kann zu erhöhter Lumineszenz, Effizienz und Lebensdauer führen.

In einer weiteren Ausführungsform umfasst die organische Funktionsschicht der Leuchtdiode eine strahlungsemittierende Schicht, die z.B. Licht im sichtbaren Wellenlängenbereich emittieren kann. Dabei kommt es bei Anlegen eines elektrischen Feldes an der ersten und zweiten Elektrode zur Aussendung von Strahlung aus der elektrolumineszierenden organischen Funktionsschicht aufgrund der Rekombination von Löchern und Elektronen (Elektrolumineszenz). Je nachdem welche der Elektroden transparent ausgebildet ist, kann Licht nach oben oder nach unten emittiert werden.

Weiterhin kann in dem elektrischen organischen Bauelement zwischen der organischen Funktionsschicht und der zweiten Elektrode eine zweite elektrisch halbleitende Schicht vorhanden sein. Damit kann auch an der zweiten Elektrode der Ladungstransport durch günstige Dotierung der zweiten elektrisch halbleitenden Schicht von der zweiten Elektrode hin zur organischen Funktionsschicht verbessert werden. An der dotierten elektrischen halbleitenden Schicht kann dabei keine oder nur eine geringe Spannung abfallen, so dass der Ladungstransport in die jeweilige angrenzende Schicht verbessert werden kann.

Die Erfindung betrifft weiterhin ein Verfahren zur Herstellung eines elektrischen Bauelements mit den oben genannten Merkmalen. Das Verfahren umfasst die Verfahrensschritte A) Bereitstellen eines Substrats und B) Erzeugen einer funktionellen Schichtanordnung auf dem Substrat. Die Schichtanordnung umfasst dabei eine erste Elektrode, eine auf der ersten Elektrode angeordnete erste elektrisch halbleitende Schicht mit Rheniumverbindungen als Dotierstoffe, eine auf der ersten elektrisch halbleitenden Schicht angeordnete organische Funktionsschicht und eine auf der Funktionsschicht angeordnete zweite Elektrode. In einer weiteren Ausführungsform umfasst der Verfahrensschritt B) die Verfahrensschritte B1) Erzeugen der ersten Elektrode auf dem Substrat, B2) Erzeugen der ersten elektrisch halbleitenden Schicht mit Rheniumverbindungen, beispielsweise Rhenium-oxo-verbindungen, als Dotierstoffe auf der ersten Elektrode, B3) Erzeugen der organischen Funktionsschicht auf der ersten elektrisch halbleitenden Schicht und B4) Erzeugen einer zweiten Elektrode auf der organischen Funktionsschicht.

Weiterhin kann in dem Verfahren im Verfahrensschritt B2) der Dotierstoff und ein Matrixmaterial gleichzeitig auf der ersten Elektrode abgeschieden werden. In einer weiteren Ausführungsform wird im Verfahrensschritt B2) das Verhältnis zwischen Dotierstoff und Matrixmaterial mittels des Verhältnisses zwischen Abscheidungsrate des Dotierstoffs und Abscheidungsrate des Matrixmaterials eingestellt. Damit kann das Verhältnis Matrixmaterial zu Dotierstoff beliebig zwischen 0,001 und 1 variiert werden. Weiterhin kann im Verfahrensschritt B2) während der Erzeugung der elektrisch halbleitenden Schicht das Molverhältnis Matrixmaterial zu Dotierstoff variiert werden, so dass ein Gradient des Molverhältnisses von Matrixmaterial zu Dotierstoff innerhalb der abgeschiedenen Schicht entsteht. Damit können in der elektrisch halbleitenden Schicht die leitenden Funktionen in Abhängigkeit der Schichtdicke eingestellt werden. Weiterhin kann im Verfahrensschritt B2) ein Komplex aus Dotierstoff und Matrixmaterial als erste elektrisch halbleitende Schicht abgeschieden werden.

In einer weiteren Ausführungsform wird im Verfahrensschritt B2) die halbleitende Schicht mit einer Schichtdicke von 30 nm abgeschieden. Weiterhin kann in einem Verfahrensschritt C1) eine erste undotierte elektrisch halbleitende

Schicht abgeschieden werden. Über der elektrisch halbleitenden dotierten Schicht kann somit eine undotierte elektrisch halbleitende Schicht erzeugt werden, die verhindert, dass der Dotierstoff die Funktion der organischen Funktionsschicht beeinträchtigt. Weiterhin kann die erste undotierte elektrisch halbleitende Schicht im Verfahrensschritt C1) mit einer Schichtdicke von 10 nm abgeschieden werden. In einer weiteren Ausführungsform können in einem Verfahrensschritt C2) weitere Funktionsschichten auf der ersten elektrisch halbleitenden Schicht erzeugt werden. Das elektrisch organische Bauelement kann damit je nach Verwendungszweck gestaltet werden kann.

Weiterhin kann im Verfahrensschritt A) ein Glassubstrat bereitgestellt werden. Im Falle der Verwendung einer Leuchtdiode als organisches elektrisches Bauelement kann Strahlung, z. B. Licht durch das Substrat emittiert werden.

Weiterhin kann im Verfahrensschritt B2) die erste Elektrode als Anode geschaltet werden. In einer weiteren Ausführungsform kann im Verfahrensschritt B2) die erste Elektrode als Kathode geschaltet werden. Die Reihenfolge der Schichten in dem organischen elektrischen Bauelement kann somit je nach Bedarf variiert werden kann.

Anhand der Figuren und der Ausführungsbeispiele soll die Erfindung näher erläutert werden:

Figur 1 zeigt eine schematische Seitenansicht des elektrischen organischen Bauelements.

Figur 2 zeigt Stromspannungskennlinien von elektrisch halbleitenden Schichten mit verschieden hoher Dotierung an Rhenium-oxo-verbindungen.

Figur 3a zeigt UV/VIS-Spektren von elektrisch halbleitenden Schichten mit verschieden hoher Dotierung an Rhenium-oxo-verbindungen.

Figur 3b zeigt Photolumineszenzspektren von elektrisch halbleitenden Schichten mit verschieden hoher Dotierung an Rhenium-oxo-verbindungen.

Figur 4 zeigt Impedanzspektren von elektrisch halbleitenden Schichten mit verschieden hoher Dotierung an Rhenium-oxo-verbindungen.

Figur 5 zeigt Stromspannungskennlinien von verschiedenen Leuchtdioden in linearer und logarithmischer Auftragungsweise.

Figur 6 zeigt die Leuchtdichte in Abhängigkeit der Spannung von verschiedenen Leuchtdioden in linearer und logarithmischer Auftragungsweise.

Figur 7a zeigt die Stromeffizienz in Abhängigkeit der Spannung von verschiedenen Leuchtdioden.

Figur 7b zeigt die Leistungseffizienz von verschiedenen Leuchtdioden in Abhängigkeit der Lumineszenz.

Figur 8 zeigt die Kapazität in Abhängigkeit der Frequenz von verschiedenen Leuchtdioden.

Figur 1 zeigt die schematische Seitenansicht einer Ausführungsform des erfindungsgemäßen elektrischen organischen Bauelements. Auf einem Substrat 1 befindet sich eine erste Elektrode 2, auf dieser die erste elektrisch halbleitende Schicht 3, darauf eine organische Funktionsschicht 4 und schließlich eine zweite Elektrode 5. Das Substrat kann beispielsweise ein Glassubstrat sein. Die erste oder zweite Elektrode kann aus einem Material sein, das aus einer Gruppe ausgewählt ist, die Metalle und deren Legierungen, Edelmetalle und deren Legierungen, Metalloxide und dotierte Polymere umfasst. Beispielsweise kann die erste und/oder zweite Elektrode Indium-Zinnoxid (ITO) umfassen, oder Aluminium oder $AlMg_3$. Es sind aber auch weitere beliebige Metalle als Material für die erste und/oder zweite Elektrode möglich. Die erste elektrisch halbleitende Schicht 3 umfasst ein Matrixmaterial sowie einen Dotierstoff. Das Matrixmaterial kann organische Materialien umfassen, die Elektronendonorfunktionen aufweisen und kann aus einer Gruppe ausgewählt sein, die Phenantrolinderivate, Imidazolderivate, Thiazolderivate, Oxadiazolderivate, Phenyl-haltige Verbindungen, Verbindungen mit kondensierten Aromaten, Carbazol-haltige Verbindungen, Fluorenderivate, Spirofluorenderivate und Pyridin-haltige Verbindungen sowie beliebige Kombinationen der genannten Materialen umfasst. Beispiele für solche Matrixmaterialien sind Bphen, BCP, TPBi, TAZ, Bu-PBD, DPVBi, Rubren, $\alpha$-NPD (NPB), 1-TNATA, CBP, BCzVBi, wobei Rubren und BCzVBi auch als emittierende Materialien eingesetzt werden können. Der Dotierstoff umfasst Rheniumverbindungen, die Rheniumoxide, metallorganische Derivate von Rheniumoxiden und Rheniumoxyhalogenide sowie Mischungen daraus sein können. Der Dotierstoff kann $Re_2O_7$ umfassen. Weiterhin kann der Dotierstoff eine $ReO_3$-Einheit umfassen, an die ein Rest M gebunden ist, der organisch sein kann. Der Rest M kann an die $ReO_3$ Einheit $\sigma$-gebunden sein. In diesem Fall umfasst der Rest M gesättigte aliphatische Gruppen, ungesättigte aliphatische Gruppen, Aromaten, Anionen der Carbonsäuren, Halogene, Stanylreste und Silylreste. Die aliphatischen Gruppen, Aromaten und Anionen

der Carbonsäuren können weiterhin Substituenten aufweisen. Der Rest M kann an die $ReO_3$-Einheit π-gebunden sein. In diesem Fall kann der Rest M unsubstituiertes oder substituiertes Cyclopentadienyl ($C_5R_xH_{5-x}$) umfassen, wobei x = 1-5 und R unabhängig voneinander ein Methyl-, Ethyl- und Phenyl-Rest sein kann. Der Dotierstoff und das Matrixmaterial bilden einen Komplex. Dieser zeichnet sich durch besondere Temperaturstabilität bis zu 400°C sowie leichte Sublimierbarkeit und Prozessierbarkeit aus. Das Molverhältnis von Matrixmaterial zu Dotierstoff kann je nach Bedarf zwischen 0,001 und 1 variiert werden. Weiterhin kann innerhalb der elektrisch halbleitenden Schicht 3 das Molverhältnis Matrix zu Dotierstoff variiert werden, so dass ein Gradient entsteht. Die elektrisch halbleitende Schicht 3 kann eine Ladungstransport-/Ladungsinjektionsschicht umfassen, zum Beispiel eine Lochtransport-/Lochinjektionsschicht. Weiterhin kann die erste Elektrode 2 als Anode geschaltet sein. Die organische Funktionsschicht 4 kann eine lichtemittierende Schicht umfassen. Das in Figur 1 dargestellte elektrische organische Bauelement kann eine Leuchtdiode sein. Weiterhin kann es ein Feldeffekttransistor, eine Solarzelle oder Photodetektoren umfassen. Im Falle eines Feldeffekttransistors sind eine Source-Elektrode, eine Gate-Elektrode und eine Drain-Elektrode vorhanden (hier nicht gezeigt), wobei die Source- und Drain-Elektroden dotiert sind und zwischen ihnen ein undotierter oder dotierter Halbleiter liegt.

Die Einführung von Rheniumverbindungen, beispielsweise Rhenium-oxo-verbindungen, als p-Dopanden in der elektrisch halbleitenden Schicht 3 führt zu verbesserten Leitfähigkeiten der elektrisch halbleitenden Schicht und zu einer stabilen p-Dotierung, die die Effizienz und Lebensdauer des Bauelements erhöht und die bewirkt, dass das Material der ersten und/oder zweiten Elektrode unabhängig gewählt werden kann.

In den Figuren 2 bis 4 werden die elektrischen Eigenschaften von dotierten elektrisch halbleitenden Schichten dargestellt, in den Figuren 5 bis 8 die elektrischen Eigenschaften von Leuchtdioden, die eine dotierte elektrisch halbleitende Schicht aufweisen.

Figur 2 zeigt die Stromspannungskennlinie für nicht erfindungsgemäße elektrisch halbleitende Schichten, die eine unterschiedlich hohe Konzentration an Dotierstoff $Re_2O_7$ in dem Matrixmaterial NPB aufweisen. Die mit $Re_2O_7$ dotierten NPB-Schichten befinden sich zwischen einer ITO-Anode und einer Al-Kathode, die jeweils eine Dicke von ca. 100 bis 150 nm haben. Die Kurve 6 zeigt die Stromspannungskennlinie einer undotierten elektrisch halbleitenden Schicht aus dem Matrixmaterial NPB zwischen der ITO-Anode und der Al-Kathode. Die mit 7 bezeichnete Kurve zeigt die Stromspannungskennlinie einer zwischen den Elektroden angeordneten elektrisch halbleitenden Schicht aus NPB, die mit 1% $Re_2O_7$ dotiert ist. In der mit 8 bezeichneten Kurve ist die elektrisch halbleitende Schicht mit 10% $Re_2O_7$ dotiert, in der mit 9 bezeichneten Kurve mit 50% und in der mit 10 bezeichneten Kurve besteht die elektrisch halbleitende Schicht zu 100% aus $Re_2O_7$. Alle elektrisch halbleitenden Schichten mit unterschiedlich hoher Dotierung, deren Stromspannungskennlinien in den Kurven 6 bis 10 dargestellt sind, weisen eine Dicke von 150 nm auf. Die undotierte elektrisch halbleitende Schicht, deren Stromspannungskennlinie in der Kurve 6 dargestellt ist, dient als Referenzwert. Aufgetragen in Figur 2 ist die Stromdichte J in Abhängigkeit von der Spannung U. Bei einer Stromdichte J von 500 $mA/cm^2$ wurde keine Messung mehr durchgeführt, um das Bauelement thermisch nicht zu zerstören. Dieser Grenzwert ist ebenfalls im Diagramm eingezeichnet. Mit zunehmender Spannung U steigt die Stromdichte, sowohl für wachsende positive Spannungen (hier dient die ITO-Elektrode als Ladungsinjektionsschicht) als auch für wachsende negative Spannungen (hier dient die Al-Elektrode als Ladungsinjektionsschicht). Es ist deutlich zu sehen, dass die Anfangswerte bei einer Spannung von 0 Volt mit zunehmender Dotierung ansteigen. Der Anstieg der Stromdichte J bei angelegter Spannung steigt umso schneller an, je höher die Dotierung in der elektrisch halbleitenden Schicht ist. Beispielsweise verbessert eine 10%ige Rheniumoxid Dotierung in der elektrisch halbleitenden Schicht die Leitfähigkeit bei 2 Volt um fünf Dekaden im Vergleich zu der undotierten Referenzschicht (Kurve 6). Reines Rheniumoxid (Kurve 10) weist die höchsten Stromdichten auf.

Figur 3a zeigt die niht erfindungsgemäßen UV/VIS-Spektren 6, 7, 8 und 9 der jeweiligen elektrisch halbleitenden Schichten, bei dem die normalisierte Intensität $I_n$ gegen die Wellenlänge λ aufgetragen ist Die halbleitenden Schichten befinden sich zur Messung auf einer Glasplatte. Das Spektrum 6 beschreibt die Absorption einer undotierten elektrisch halbleitenden Schicht aus dem Matrixmaterial NPB. Das Spektrum 7 zeigt die Absorption einer elektrisch halbleitenden Schicht aus NPB, die mit 1% $Re_2O_7$ dotiert ist. In dem mit 8 bezeichneten Spektrum ist die elektrisch halbleitende Schicht mit 10% $Re_2O_7$ dotiert, in dem mit 9 bezeichneten Spektrum mit 50%. Alle Spektren zeigen einen Peak bei ca. 350 nm, dieser wird durch eine erhöhte Dotierung mit $Re_2O_7$ nicht verändert. Mit zunehmend hoher Dotierung in der elektrisch halbleitenden Schicht weisen die Spektren aber einen zunehmend höheren Absorptionspeak bei Wellenlängen zwischen 450 nm und 550 nm auf. Dieser Absorptionspeak entsteht aufgrund von Ladungstransfer in der elektrisch halbleitenden Schicht und zeigt, dass zwischen dem $Re_2O_7$ und dem Matrixmaterial NPB ein charge-transfer Komplex gebildet wird. Da dieser Peak im Vergleich zu anderen Dotierstoffen (hier nicht gezeigt) besonders klein ist, wird dadurch die günstige Wirkung von $Re_2O_7$ als Dotierstoff gezeigt. Das in dieser Abbildung nicht gezeigte Spektrum einer 100%igen $Re_2O_7$-Schicht als elektrisch halbleitende Schicht zeigt keine Absorption. Die Figur 3a zeigt, dass die Lichtabsorption von NPB durch die Dotierung mit Rheniumoxid unverändert bleibt.

Figur 3b zeigt nicht erfindungsgemäß, Photolumineszenzspektren 6, 7, 8 und 9 der elektrisch halbleitenden Schichten, bei dem die Intensität I gegen die Wellenlänge λ aufgetragen ist. Die Anregungswellenlänge beträgt 344 nm. Die halbleitenden Schichten befinden sich zur Messung auf einer Glasplatte. Das Spektrum 6 beschreibt die Photolumineszenz einer undotierten elektrisch halbleitenden Schicht aus dem Matrixmaterial NPB. Das mit 7 bezeichnete

Spektrum zeigt die Photolumineszenz einer elektrisch halbleitenden Schicht aus NPB, die mit 1% $Re_2O_7$ dotiert ist. In dem mit 8 bezeichneten Spektrum ist die elektrisch halbleitende Schicht mit 10% $Re_2O_7$ dotiert, in dem mit 9 bezeichneten Spektrum mit 50%. Die Spektren zeigen, dass mit zunehmend hoher Dotierung in der elektrisch halbleitenden Schicht die Intensität des Peak-Maximums bei ca. 450 nm abnimmt. Das bedeutet, dass $Re_2O_7$ die Fluoreszenzen von NPB mit zunehmendem Dotierungsgrad löscht bzw. vermindert.

Figur 4 zeigt nicht erfindungsgemäße Impedanzspektren 7, 8, 9 und 10 der elektrisch halbleitenden Schichten, bei dem der Leitwert G in 1/Ω gegen die Frequenz f in Hz aufgetragen ist. Die halbleitenden Schichten befinden sich zur Messung auf einer Glasplatte. Der Leitwert G hängt mit der Leitfähigkeit $\sigma_{dc}$ folgendermaßen zusammen:

$$\sigma_{dc}=\lim_{f->0}\cdot G\cdot A/d$$

Hier ist $\sigma_{dc}$ die Leitfähigkeit in S/cm, G der Leitwert in 1/Ω, A die Fläche in $cm^2$ und d der Abstand in cm. Es ist deutlich zu sehen, dass das Spektrum 10, das der elektrisch halbleitenden Schicht aus 100% $Re_2O_7$ zugeordnet ist, den höchsten Leitwert G aufweist. Niedrigere Dotierungen (Spektren 9 beschreibend eine Schicht mit 50%iger Dotierung, 8 und 7) haben niedrigere Leitwerte G, bei einer Dotierung von 1% (7) oder 10% (8) steigen die Leitwerte erst bei Frequenzen größer $10^4$ Hz an. Das zeigt, dass die Dotierung in der elektrisch halbleitenden NPB Schicht die Leitfähigkeit verbessert. Die Leitfähigkeiten sind in Abhängigkeit der verschiedenen Dotierungen in Tabelle 1 aufgetragen:

Tabelle 1

| Konzentration $Re_2O_7$ | $\sigma_{dc}$ [S/cm] |
|---|---|
| 1% | $5.86\cdot10^{-09}$ |
| 10% | $1.11\cdot10^{-07}$ |
| 50% | $3.00\cdot10^{-05}$ |
| 100% | $2.06\cdot10^{-04}$ |

Figur 5 zeigt die Stromspannungskennlinie von nicht erfindungsgemäßen Leuchtdioden mit dotierter elektrisch halbleitender Schicht. Die Leuchtdioden enthalten eine ITO-Anode von 150 nm Dicke, eine 40 nm dicke elektrisch halbleitende Schicht aus dotiertem oder undotiertem NPB, eine 20 nm dicke strahlungsemittierende Schicht aus CBP, das mit 11% $Ir(ppy)_3$ dotiert ist, eine E-lektroneninjektionsschicht mit 40 nm Dicke aus BCP, eine Kathode aus einer 0,7 nm dicken LiF- und einer 100 nm dicken Al-Schicht. Die elektrisch halbleitende Schicht besteht zu 100% aus NPB (mit 11 bezeichnete Kurve), aus einer 20 nm dicken mit 10% $Re_2O_7$-dotierten NPB-Schicht und einer 20 nm dicken reinen NPB-Schicht (mit 12 bezeichnete Kurve), aus einer 20 nm dicken, mit 50% $Re_2O_7$ dotierten NPB-Schicht und einer 20 nm dicken NPB-Schicht (mit 13 bezeichnete Kurve), und aus einer 20 nm dicken 100%igen $Re_2O_7$-Schicht und einer 20 nm dicken NPB-Schicht (mit 14 bezeichnete Kurve). In der Stromspannungskennungslinie der Leuchtdioden ist in Figur 5 linear die Stromdichte J gegen die Spannung U aufgetragen, in dem Inset in Figur 6 logarithmisch. Auch hier ist, insbesondere in der logarithmischen Auftragung, eine deutliche Verbesserung der Leitfähigkeit mit zunehmender Dotierung zu sehen. Geringere Spannungen erzeugen höhere Ströme, was zu einer höheren Lichtausbeute und damit zu einer Verbesserung der Effizienz führt. Die höchsten Stromdichten weisen die elektrisch halbleitenden Schichten mit 50%iger Dotierung (Kurve 13) beziehungsweise mit 100%igem $Re_2O_7$ in der elektrisch halbleitenden Schicht (Kurve 14) auf.

In Figur 6 sind die nicht erfindungsgemäß Leuchtdichten in $cd/m^2$ in Abhängigkeit der Spannung in V der Leuchtdioden 11 (100% NPB), 12 (10%ige Dotierung), 13 (50%ige Dotierung) und 14 (100% $Re_2O_7$) zu sehen. Es ist eine lineare sowie eine logarithmische Auftragung gezeigt. Hier ist wieder zu sehen, dass mit höherer Dotierung der elektrisch halbleitenden Schicht schneller höhere Leuchtdichten erreicht werden.

In Figur 7a ist die Stromeffizienz CE gegen die Spannung U für die bereits oben genannten nicht erfindungsgemäßen Leuchtdioden aufgetragen (Kurven 11, 12, 13 und 14). Vor allem bei hohen Spannungen U ist eine verbesserte Stromeffizienz $C_E$ bei den dotierten Leuchtdioden erkennbar.

In Figur 7b ist die Leistungseffizienz $P_E$ gegen die Lumineszenz L für die oben genannten nicht erfindungsgemäßen Leuchtdioden (Kurven 11, 12, 13 und 14) aufgetragen. Vor allem bei hohen Leuchtdichten sieht man in den Kurven 13 und 14 eine verbesserte Leistungseffizienz $P_E$. Auch hier macht sich die Dotierung der elektrisch halbleitenden Schicht positiv bemerkbar.

In Figur 8 sind Impedanzmessungen 11, 12, 13 und 14 für die oben beschriebenen nicht erfindungsgemäßen Leuchtdioden zu sehen. Die Wechselspannung beträgt 0,1 V, die Gleichspannung ist 0 V. Die Dielektrizitätskonstante $\varepsilon_0$ beträgt 3.3, die Fläche A, die gemessen wurde, beträgt 0,04 $cm^2$. Die Auftragung Kapazität C gegen Frequenz f ist

für alle Leuchtdioden gezeigt. Nimmt man eine nominelle Schichtdicke der undotierten NPB-Schicht von 100 nm an (in der Auftragung eingezeichnet), so sieht man, dass bei den dotierten Leuchtdioden ein Unterschied zu der nominellen Schichtdicke von 20 nm auftritt. Alle dotierten Leuchtdioden haben eine intrinsische Schichtdicke von 80 nm. Dies kann als Indiz für gute Leitfähigkeit gedeutet werden. Da die dotierten Leuchtdioden eine höhere Anzahl an intrinsischen Ladungsträgern aufweisen, werden sie elektrisch sozusagen "unsichtbar" und damit die Schichtdicke geringer.

Als nicht erfindungsgemäßen Ausführungsbeispiel soll die Herstellung einer Leuchtdiode mit einer elektrisch halbleitenden Schicht angegeben werden. In einer Vakuumatmosphäre wird 500 mg $Re_2O_7$ in einen beheizbaren Behälter eingefüllt. In einen zweiten Behälter wird NPB eingeführt. Eine Glasplatte von der Größe 60 mm x 60 mm, die mit einer strukturierten ITO-Elektrode bedeckt ist, wird ca. 25 cm entfernt von den beiden Behältern auf einem Substrathalter befestigt. Aus dem Behälter mit NPB wird mit einer Rate von 1 nm/s NPB auf der ITO-Elektrode abgeschieden, aus dem Behälter mit $Re_2O_7$ wird mit einer Rate von 0.1 nm/s $Re_2O_7$ abgeschieden. Aus diesem Verhältnis der Abscheidungsraten entsteht ein Verhältnis von Matrix zu Dotierstoff von 10 zu 1. Es wird so eine 30 nm dicke NPB-Schicht, die mit $Re_2O_7$ dotiert ist, abgeschieden. Anschließend wird zusätzlich eine reine 10 nm dicke NPB-Schicht auf der dotierten NPB-Schicht abgeschieden. Im Anschluss können in bekannter Weise weitere organische Funktionsschichten sowie eine Kathode durch Verdampfung abgeschieden werden. Dieses Beispiel für die Herstellung einer Leuchtdiode kann beliebig variiert werden. Beispielsweise kann das Verhältnis Matrix zu Dotierstoff 1 zu 1 oder 1000 zu 1 betragen. Anstatt NPB kann als Matrix Bphen, TAZ oder Naphthalin-Tetracarbonsäurehydrid verwendet werden. Als Dotierstoff kann statt $Re_2O_7$ auch Methyltrioxo-Rhenium, Cyclopentadienyltrioxo-Rhenium oder Pentamethylcyclopentadienyloxo-Rhenium eingesetzt werden. Für die Abscheidung auf der ITO-Elektrode kann weiterhin ein Gas-Strom verwendet werden. Bezüglich der Konzentration an Dotierstoff in der Matrix kann die Abscheidung so eingestellt werden, dass ein Gradient des Verhältnisses Matrix zu Dotierstoff von 10 zu 1 bis 10.000 zu 1 erzeugt wird. Die reine BCP-Schicht kann auch weggelassen werden. Schließlich kann auch an der Kathode mit dem Aufbau der elektrisch halbleitenden Schicht begonnen werden, was zu einer Top-Emitter-Leuchtdiode führt.

Die in den Figuren 1 bis 9 gezeigten Beispiele und die Ausführungsbeispiele zur Herstellung können im Rahmen der Erfindung variiert werden. Es ist weiterhin zu berücksichtigen, dass sich die Erfindung nicht auf diese Beispiele beschränkt, sondern weitere, hier nicht aufgeführte Ausgestaltungen zulässt.

## Patentansprüche

**1.** Elektrisches organisches Bauelement, aufweisend

- ein Substrat (1),
- eine erste Elektrode (2),
- eine erste elektrisch halbleitende Schicht (3) auf der ersten Elektrode (2),
- eine organische Funktionsschicht (4) auf der elektrisch halbleitenden Schicht (3),

und

- eine zweite Elektrode (5) auf der organischen Funktionsschicht,

wobei entweder die erste (2) oder die zweite Elektrode (5) auf dem Substrat (1) angeordnet ist und die elektrisch halbleitende Schicht (3) ein Matrixmaterial aufweist und mit einem Dotierstoff dotiert ist, **dadurch gekennzeichnet, dass** der dotierstoff Rheniumverbindungen umfasst, wobei der Dotierstoff in dem Matrixmaterial vorhanden ist und der Dotierstoff und das Matrixmaterial einen Komplex bilden, wobei der Dotierstoff eine $ReO_3$-Einheit umfasst, an die ein Rest M gebunden ist.

**2.** Bauelement nach dem vorhergehenden Anspruch, wobei das Matrixmaterial durch den Dotierstoff p-dotiert ist.

**3.** Bauelement nach einem der vorhergehenden Anspüche, wobei das Matrixmaterial lochleitend ist.

**4.** Bauelement nach einem der vorhergehenden Ansprüche, wobei die Rheniumverbindungen aus einer Gruppe ausgewählt sind, die Rheniumoxide, metallorganische Derivate von Rheniumoxiden und Rheniumoxyhalogenide und Mischungen daraus umfasst.

**5.** Bauelement nach dem vorhergehenden Anspruch, wobei der Rest M an die $ReO_3$-Einheit $\sigma$-gebunden oder $\pi$-gebunden ist.

6. Bauelement nach Anspruch 5, wobei der σ-gebundene Rest M aus einer Gruppe ausgewählt ist, die verzweigte oder unverzweigte gesättigte aliphatische Gruppen, verzweigte oder unverzweigte ungesättigte aliphatische Gruppen, Aromaten, Anionen von Carbonsäuren, Halogene, Stannylreste und Silylreste umfasst, wobei die aliphatischen Gruppen, Aromaten und Anionen der Carbonsäuren substituiert oder unsubstituiert sein können und wobei der π-gebundene Rest M unsubstituiertes oder substituiertes Cyclopentadienyl umfasst.

7. Bauelement nach Anspruch 6, wobei das substituierte Cyclopentadienyl Substituenten aufweist, die aus einer Gruppe ausgewählt sind, die unabhängig voneinander Alkylgruppen und Arylgruppen umfasst.

8. Bauelement nach einem der vorhergehenden Ansprüche, wobei die elektrisch halbleitende Schicht (3) eine Ladungstransport-/Ladungsinjektionsschicht, insbesondere eine Lochtransport-/Lochinjektionsschicht umfasst.

9. Bauelement nach einem der vorhergehenden Ansprüche, wobei das Bauelement als Feldeffekttransistor, Solarzelle oder Photodetektor ausgebildet ist oder eine Leuchtdiode umfasst.

10. Bauelement nach einem der vorhergehenden Ansprüche, wobei zwischen der organischen Funktionsschicht (4) und der zweiten Elektrode (5) eine zweite elektrisch halbleitende Schicht vorhanden ist.

11. Verfahren zur Herstellung eines elektrischen organischen Bauelements gemäß den vorhergehenden Ansprüchen, umfassend die Verfahrensschritte:

A) Bereitstellen eines Substrats (1),
B) Erzeugen einer funktionellen Schichtanordnung auf dem Substrat, wobei die Schichtanordnung eine erste Elektrode (2), eine auf der ersten Elektrode angeordnete erste elektrisch halbleitende Schicht (3) mit Rheniumverbindungen als Dotierstoffe, eine auf der ersten elektrisch halbleitenden Schicht angeordnete organische Funktionsschicht (4) und eine auf der Funktionsschicht angeordnete zweite Elektrode (5) umfasst.

12. Verfahren nach dem vorhergehenden Anspruch, wobei auf die dotierte elektrisch halbleitende Schicht (3) in einem Verfahrensschritt C1) eine erste undotierte elektrisch halbleitende Schicht abgeschieden wird.

## Claims

1. Electrical organic component comprising

- a substrate (1),
- a first electrode (2),
- a first electrically semiconducting layer (3) on the first electrode (2),
- an organic functional layer (4) on the electrically semiconducting layer (3),

and

- a second electrode (5) on the organic functional layer,

wherein either the first (2) or the second electrode (5) is arranged on the substrate (1) and the electrically semiconducting layer (3) comprises a matrix material and is doped with a dopant, **characterized in that** the dopant comprises rhenium compounds, wherein the dopant is present in the matrix material and the dopant and the matrix material form a complex, wherein the dopant comprises an $ReO_3$ unit to which a radical M is bonded.

2. Component according to the preceding claim, wherein the matrix material is p-doped by the dopant.

3. Component according to either of the preceding claims, wherein the matrix material is hole-conducting.

4. Component according to any of the preceding claims, wherein the rhenium compounds are selected from a group comprising rhenium oxides, organometallic derivatives of rhenium oxides and rhenium oxyhalides and mixtures thereof.

5. Component according to the preceding claim, wherein the radical M is σ-bonded or π-bonded to the $ReO_3$ unit.

6. Component according to Claim 5, wherein the σ-bonded radical M is selected from a group comprising branched or unbranched saturated aliphatic groups, branched or unbranched unsaturated aliphatic groups, aromatics, anions of carboxylic acids, halogens, stannyl radicals and silyl radicals, wherein the aliphatic groups, aromatics and anions of the carboxylic acids can be substituted or unsubstituted, and wherein the π-bonded radical M comprises unsubstituted or substituted cyclopentadienyl.

7. Component according to Claim 6, wherein the substituted cyclopentadienly has substituents selected from a group comprising, independently of one another, alkyl groups and aryl groups.

8. Component according to any of the preceding claims, wherein the electrically semiconducting layer (3) comprises a charge transport/charge injection layer, in particular a hole transport/hole injection layer.

9. Component according to any of the preceding claims, wherein the component is embodied as a field effect transistor, solar cell or photodetector or comprises a light-emitting diode.

10. Component according to any of the preceding claims, wherein a second electrically semiconducting layer is present between the organic functional layer (4) and the second electrode (5).

11. Method for producing an electrically organic component according to the preceding claims, comprising the following method steps:

A) providing a substrate (1),
B) producing a functional layer arrangement on the substrate, wherein the layer arrangement comprises a first electrode (2), a first electrically semiconducting layer (3) arranged on the first electrode and comprising rhenium compounds as dopants, an organic functional layer (4) arranged on the first electrically semiconducting layer, and a second electrode (5) arranged on the functional layer.

12. Method according to the preceding claim, wherein a first undoped electrically semiconducting layer is deposited onto the doped electrically semiconducting layer (3) in a method step C1).

**Revendications**

1. Elément de construction organique électrique, comprenant

- un substrat (1),
- une première électrode (2),
- une première couche semi-conductrice électrique (3) sur la première électrode (2),
- une couche fonctionnelle organique (4) sur la couche semi-conductrice électrique (3),

et

- une deuxième électrode (5) sur la couche fonctionnelle organique,

soit la première (2) soit la deuxième électrode (5) étant disposée sur le substrat (1) et la couche semi-conductrice électrique (3) comportant une matière matricielle et étant dopée avec une impureté de dopage, **caractérisé en ce que** l'impureté de dopage comprend des composés de rhénium, l'impureté de dopage étant présente dans la matière matricielle et l'impureté de dopage et la matière matricielle formant un complexe, l'impureté de dopage comprenant une unité de $ReO_3$ à laquelle est lié un radical M.

2. Elément de construction selon la revendication précédente, la matière matricielle étant p-dopée par l'impureté de dopage.

3. Elément de construction selon l'une quelconque des revendications précédentes, la matière matricielle étant une matière conductrice à trous.

4. Elément de construction selon l'une quelconque des revendications précédentes, les composés de rhénium étant choisis dans un groupe comprenant les oxydes de rhénium, les dérivés métallo-organiques des oxydes de rhénium

et les halogénures de rhénium, ainsi que des mélanges de ces derniers.

5. Elément de construction selon la revendication précédente, le radical M étant lié par $\sigma$ ou lié par $\pi$ à l'unité $ReO_3$.

6. Elément de construction selon la revendication 5, le radical M lié par $\sigma$ étant choisi dans un groupe qui comprend des groupes aliphatiques ramifiés ou linéaires saturés, des groupes aliphatiques ramifiés ou linéaires non saturés, des aromates, des anions d'acides carboxyliques, des halogènes, des radicaux stannyle et des radicaux silyle, les groupes aliphatiques, les aromates et les anions d'acides carboxyliques pouvant être substitués ou non substitués et le radical M lié par $\pi$ comprenant du cyclopentadiényle substitué ou non substitué.

7. Elément de construction selon la revendication 6, le cyclopentadiényle substitué comportant des substituants qui sont choisis dans un groupe qui, indépendamment l'un de l'autre, comprend des groupes alkyle et des groupes aryle.

8. Elément de construction selon l'une quelconque des revendications précédentes, la couche semi-conductrice électrique (3) comprenant une couche de transport de charge/d'injection de charge, notamment une couche de transport de trous/d'injection de trous.

9. Elément de construction selon l'une quelconque des revendications précédentes, l'élément de construction étant conçu en tant que transistor à effet de champ, en tant que cellule solaire ou en tant que photodétecteur ou comprenant une diode électroluminescente.

10. Elément de construction selon l'une quelconque des revendications précédentes, une deuxième couche semi-conductrice électrique étant présente entre la couche fonctionnelle organique (4) et la deuxième électrode (5).

11. Procédé de fabrication d'un élément de construction organique électrique selon les revendications précédentes, comprenant les étapes de procédé :

A) mise à disposition d'un substrat (1),
B) création d'un agencement fonctionnel de couches sur le substrat, l'agencement de couches comprenant une première électrode (2), une première couche semi-conductrice électrique (3) disposée sur la première électrode, avec des composés de rhénium en tant qu'impuretés de dopage, une couche fonctionnelle organique (4) disposée sur la première couche semi-conductrice électrique et une deuxième électrode (5) disposée sur la couche fonctionnelle.

12. Procédé selon la revendication précédente, dans une étape de procédé C1), une première couche semi-conductrice électrique non dopée étant déposée sur la couche semi-conductrice électrique (3) dopée.

FIG 1

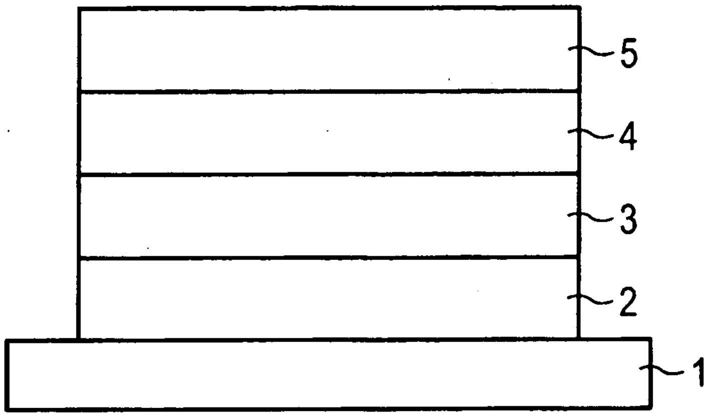
5
4
3
2
1

FIG 2

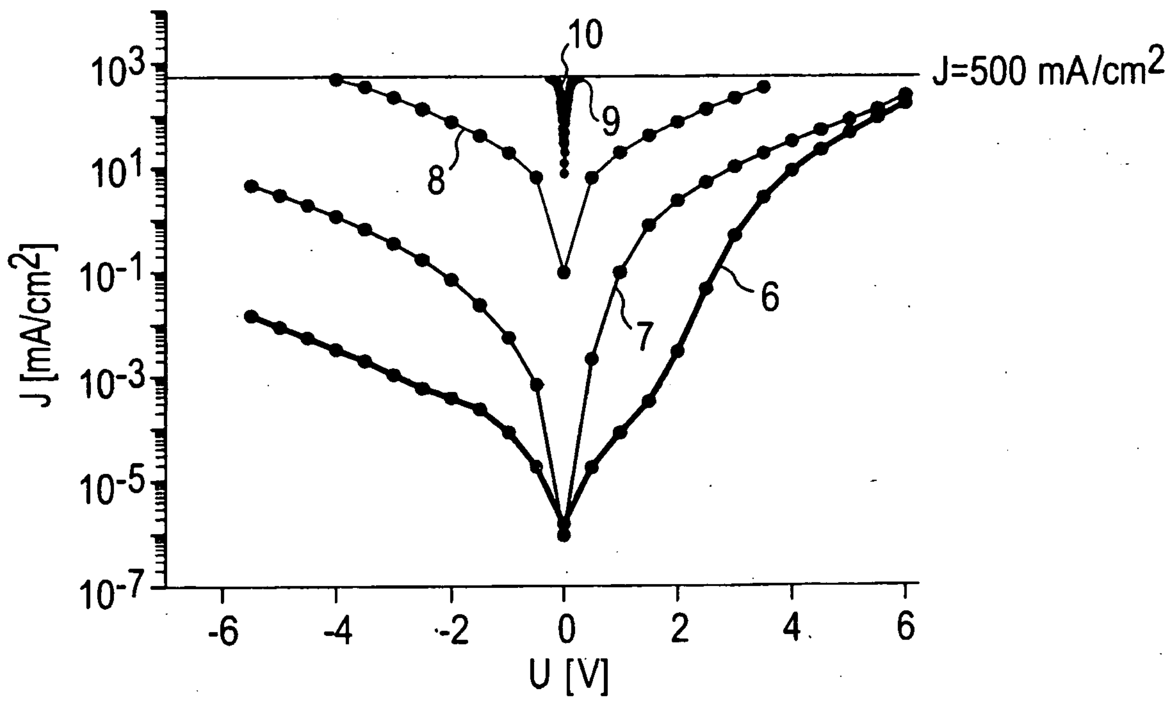
10
9
8
7
6
J=500 mA/cm2
10^3
10^1
10^-1
10^-3
10^-5
10^-7
J [mA/cm2]
-6
-4
-2
0
2
4
6
U [V]

FIG 3A

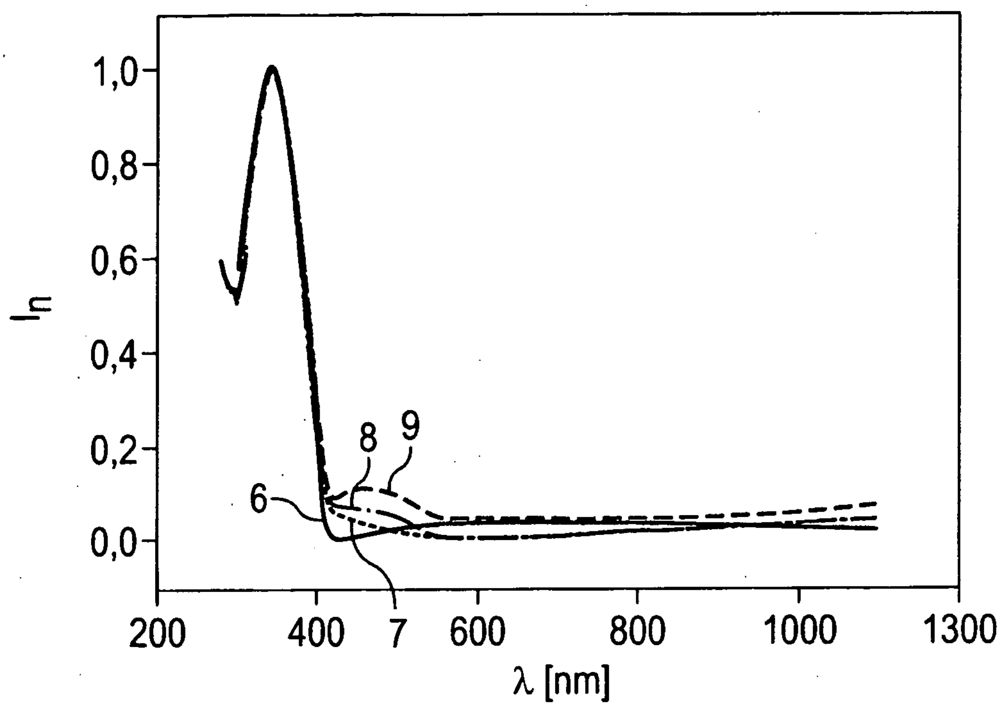
1,0
0,8
0,6
0,4
0,2
0,0
$I_n$
6
7
8
9
200
400
600
800
1000
1300
λ [nm]

FIG 3B

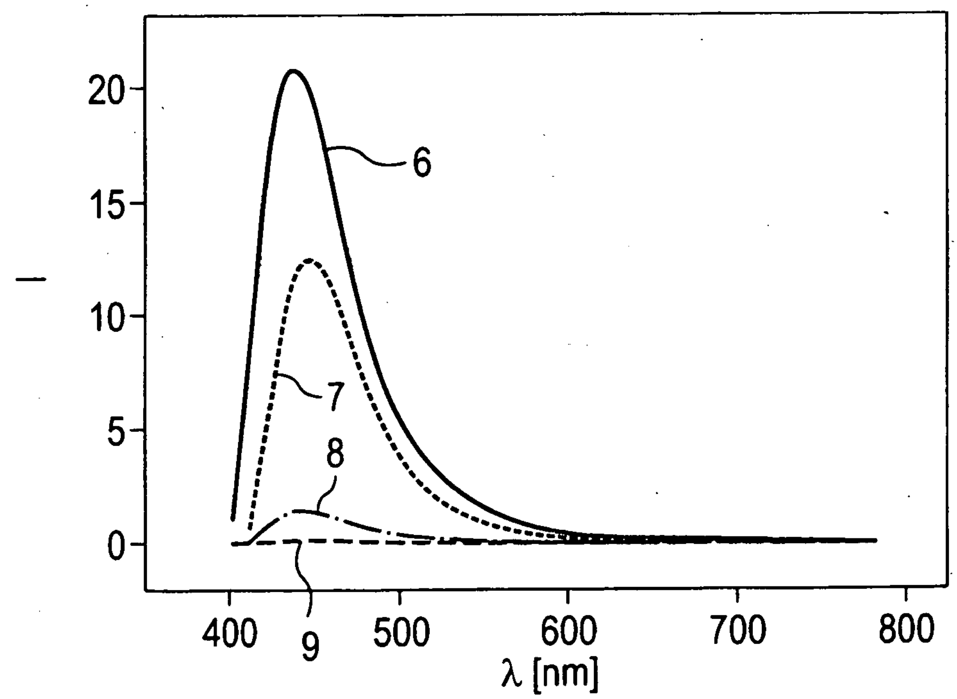
20
15
10
5
0
I
6
7
8
9
400
500
600
700
800
λ [nm]

FIG 4

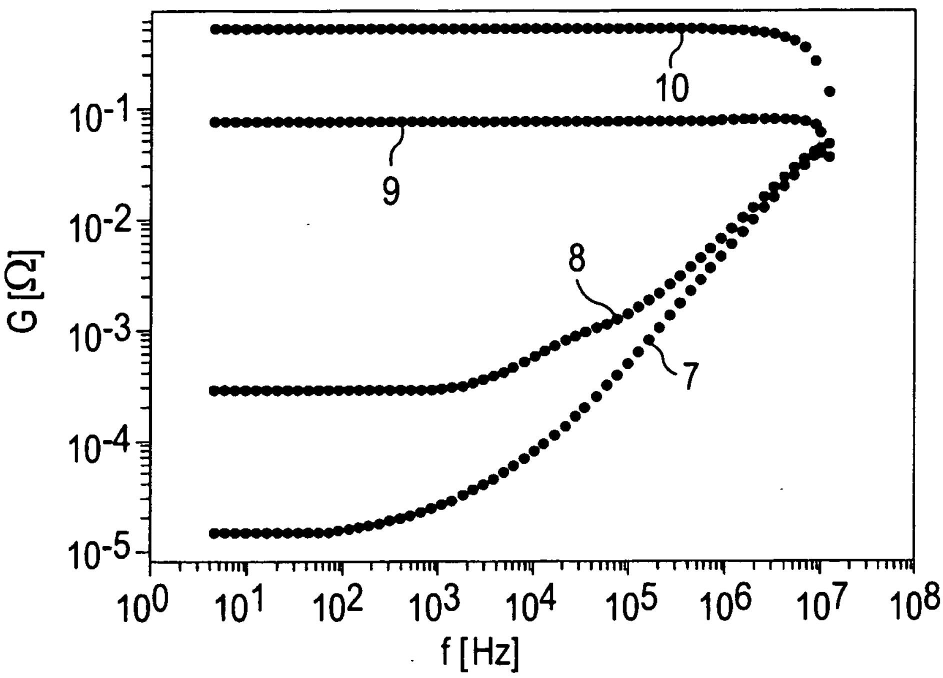
G [Ω]
10-1
10-2
10-3
10-4
10-5
10
9
8
7
10^0 10^1 10^2 10^3 10^4 10^5 10^6 10^7 10^8
f [Hz]

FIG 5

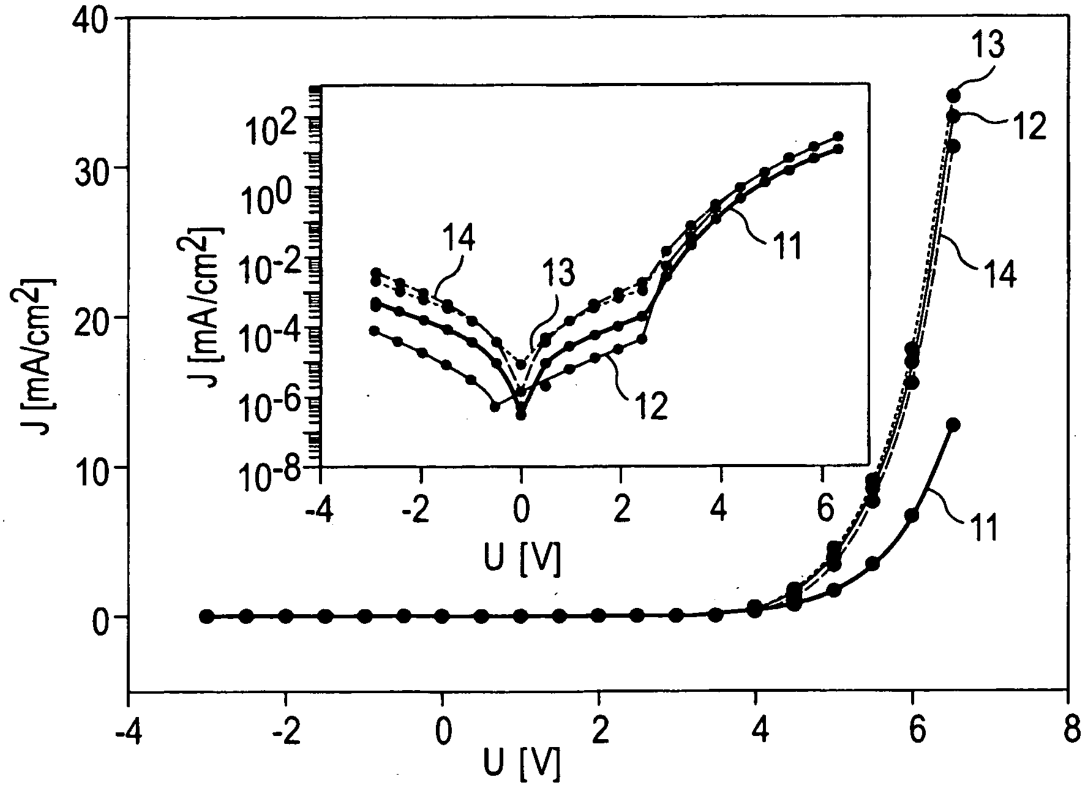
J [mA/cm2]
40
30
20
10
0
-4 -2 0 2 4 6 8
U [V]
13
12
14
11
J [mA/cm2]
10^2
10^0
10^-2
10^-4
10^-6
10^-8
-4 -2 0 2 4 6
U [V]

FIG 6

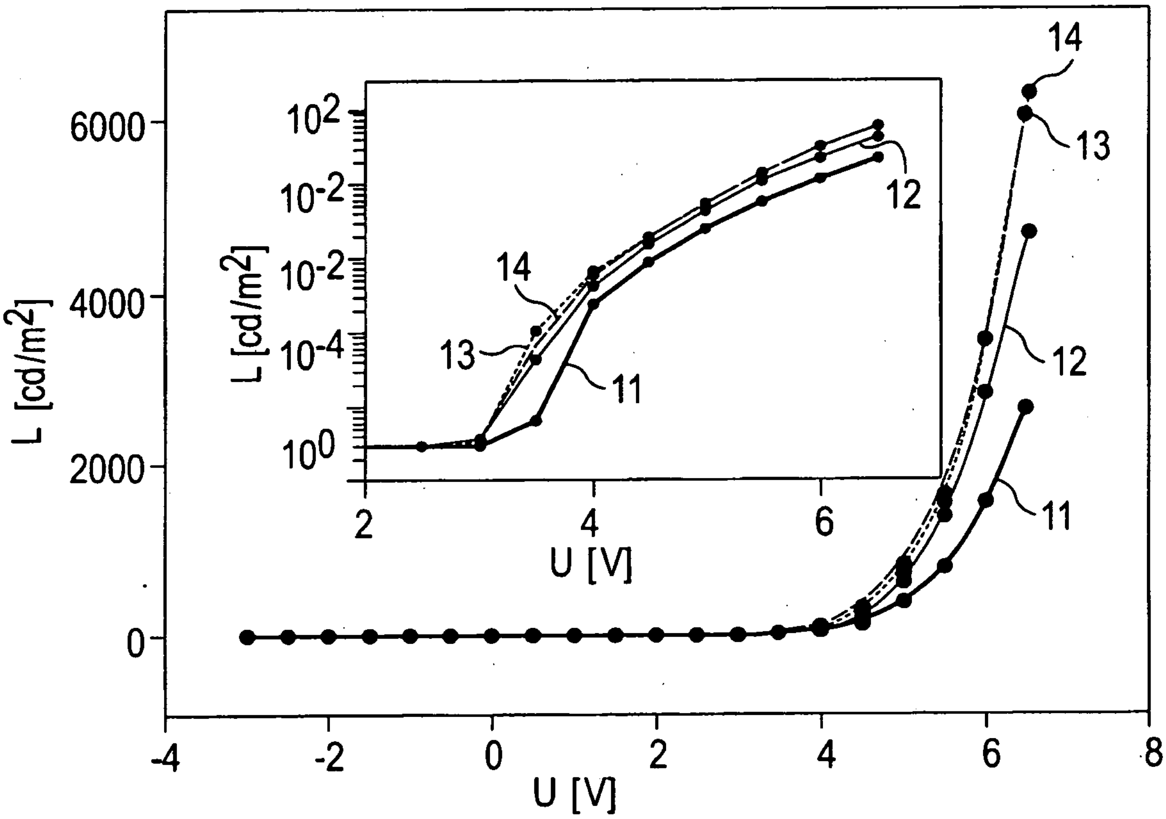
L [cd/m2]
6000
4000
2000
0
-4
-2
0
2
4
6
8
U [V]
14
13
12
11
L [cd/m2]
10^2
10^-2
10^-2
10^-4
10^0
2
4
6
U [V]
14
13
11
12

FIG 7A

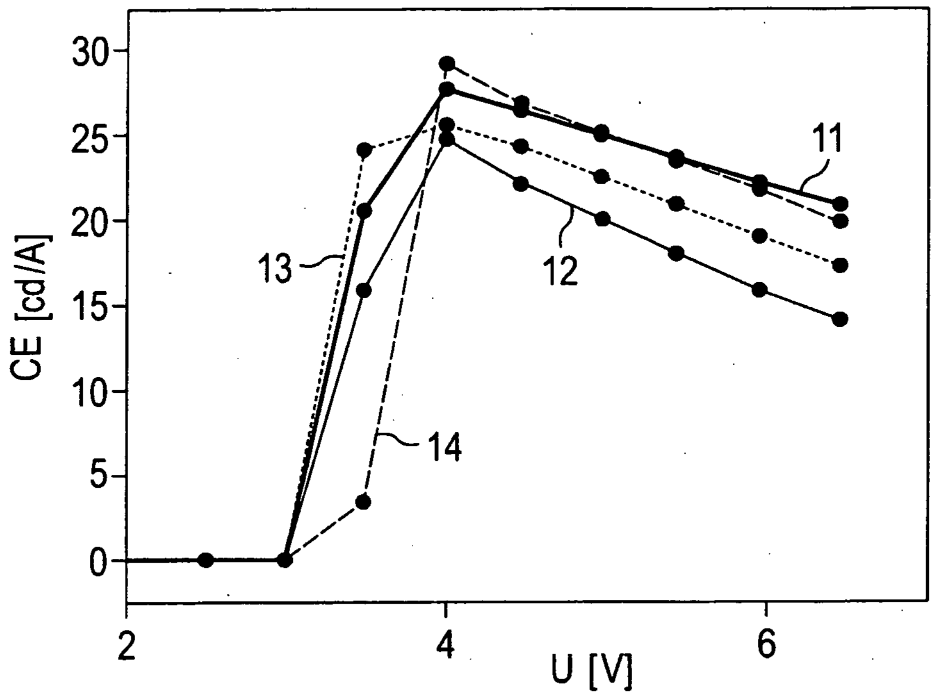
30
25
20
15
10
5
0
CE [cd/A]
2
4
6
U [V]
11
12
13
14

FIG 7B

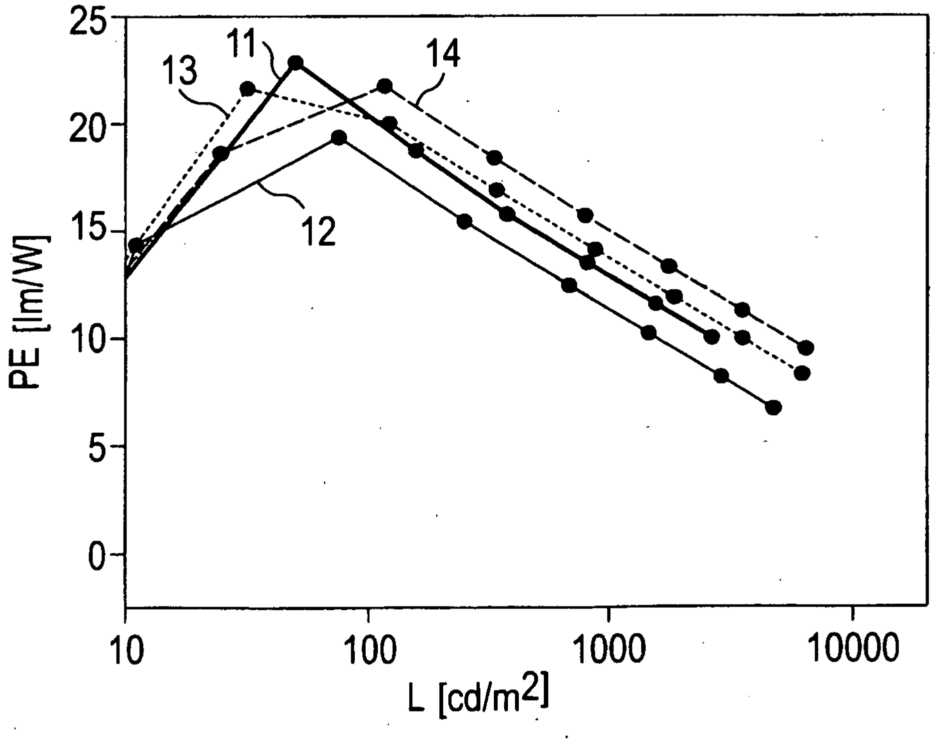
25
20
15
10
5
0
PE [lm/W]
10
100
1000
10000
L [cd/m2]
11
12
13
14

FIG 8

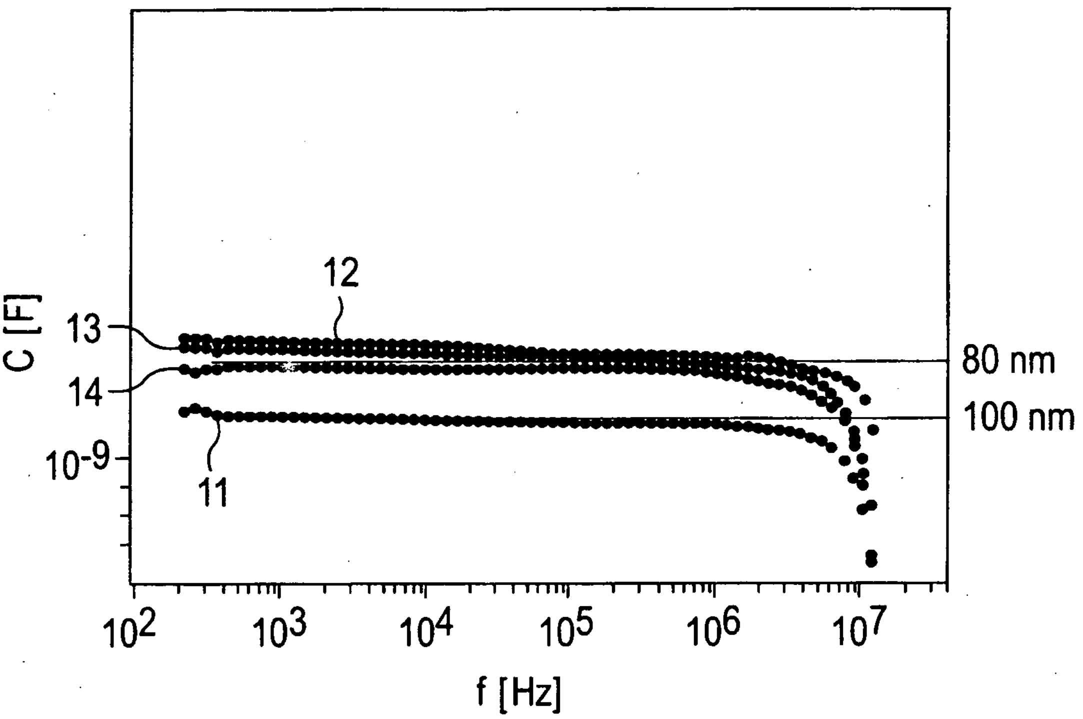

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 20060076537 A